Europäisches Patentamt

European Patent Office

Office européen des brevets

(19)

(11) **EP 0 554 184 B1**

(12) **FASCICULE DE BREVET EUROPEEN**

(45) Date de publication et mention
de la délivrance du brevet:
**23.07.1997 Bulletin 1997/30**

(51) Int Cl.⁶: **G11C 19/08**, G01D 5/14

(21) Numéro de dépôt: **93400234.6**

(22) Date de dépôt: **29.01.1993**

(54) **Dispositif compteur de tours comportant un micro-circuit à bulles magnétiques**

Drehzähleranordnung mit magnetischer Blasenmikroschaltung

Rotations counter devices having a magnetic bubble micro-circuit

(84) Etats contractants désignés:
DE GB IT

(30) Priorité: **31.01.1992 FR 9201099**

(43) Date de publication de la demande:
**04.08.1993 Bulletin 1993/31**

(73) Titulaire: **SAGEM SA**
**F-75783 Paris Cédex 16 (FR)**

(72) Inventeurs:
• **Poirier, Michel**
**F-95300 Pontoise (FR)**
• **Pougnet, Philippe**
**F-95000 Cergy-Pontoise (FR)**
• **Zimmermann, Laurent**
**92270 Bois Colombes (FR)**

(74) Mandataire: **Fort, Jacques et al**
**CABINET PLASSERAUD**
**84, rue d'Amsterdam**
**75009 Paris (FR)**

(56) Documents cités:
CH-A- 513 490        US-A- 3 895 363
US-A- 3 961 316        US-A- 4 990 909

• PATENT ABSTRACTS OF JAPAN vol. 15, no. 247
25 Juin 1991 & JP-A-30 78619 ( FANUC LDT ) 3
Avril 1991

**Description**

L'invention a pour objet un dispositif permettant de compter et de mémoriser le nombre de tours d'un organe tournant, utilisant un micro-circuit à bulles magnétiques. Elle est applicable chaque fois qu'il est possible de ramener une mesure au comptage absolu du nombre des révolutions d'un organe qu'on peut munir d'un aimant.

On connaît déjà des dispositifs compteurs de tours à micro-circuit à bulles magnétiques. Typiquement un tel dispositif comporte un aimant constituant l'organe rotatif ou porté par lui et un micro-circuit ayant un substrat portant des boucles de comptage à circulation de bulles magnétiques, placées par rapport à l'aimant de façon que le champ tournant de l'aimant fasse passer les bulles d'un motif à l'autre de chaque boucle à chaque rotation du champ. Un intérêt majeur d'un tel dispositif est qu'il ne nécessite aucune alimentation électrique, une fois qu'une bulle au moins a été générée dans chaque boucle, jusqu'à ce qu'une lecture du compteur devienne nécessaire. Il met au surplus en oeuvre une technologie qui est à l'heure actuelle bien maîtrisée et peut être aisément miniaturisée.

Mais non seulement l'opération de lecture exige un détecteur de la position des bulles magnétiques qui est un élément actif exigeant une alimentation, mais encore cette opération fait apparaître un certain nombre de problèmes et de limitations qui, jusqu'ici, n'ont pas été traités de façon entièrement satisfaisante.

Une limitation manifeste existe lorsqu'une seule bulle a été créée dans chaque boucle. La mesure n'est possible que lorsque la bulle passe devant le détecteur, ce qui implique de munir le dispositif de moyens de création d'un champ tournant servant à propager les bulles et provoque de toute façon un retard de lecture. Les moyens de création du champ tournant seront généralement constitués par un couple de bobines croisées, générant chacune un champ situé dans le plan des boucles et pouvant être alimentées en courants alternatifs. Le retard peut être réduit en générant dans chaque boucle non pas une bulle, mais une séquence particulière de bulles.

Du fait que le signal électrique dû au passage d'une bulle sous le détecteur, généralement magnéto-résistif, est faible, il est nécessaire, surtout en cas de mesure "au vol" (alors que l'aimant tourne et que le compteur fonctionne) d'effectuer la mesure alors que le champ tournant de lecture est dans son orientation optimale, ce qui implique d'ajouter un capteur de position angulaire au dispositif.

A titre d'exemple de compteur de tours du type ci-dessus, on peut citer celui qui est décrit dans le brevet US-A-4 990 909 et dans l'article "Revolution Counter Using Magnetic Bubble Device for Multi-turn Absolute Encoder" de Kohsaka et Coll., Sensors et Actuators, A 21-A 23 (1990) pp. 803-806, Elsevier Sequoia, auquel on pourra se reporter. Ce dispositif utilise, comme capteur de position angulaire, un codeur angulaire optique. Ce codeur est encombrant et coûteux. Il comporte obligatoirement au moins une pièce mécanique en mouvement. Sa consommation est relativement élevée. Dans la pratique, la lecture ne peut se faire qu'alors que le compteur est arrêté : l'angle du champ tournant est mesuré ; les bobines sont utilisées pour compenser le champ de l'aimant. La mesure implique une circulation importante des bulles, qui doit ensuite être compensée par un mouvement de retour.

La présente invention vise à fournir un dispositif compteur du genre ci-dessus défini répondant mieux que ceux antérieurement connus aux exigences de la pratique, notamment en ce qu'il élimine la nécessité d'une pièce mobile pour autoriser la lecture. Dans ce but, l'invention propose notamment un dispositif comportant de plus une boussole électronique sensible au champ magnétique tournant des moyens de lecture. Cette boussole ne comporte pas d'élément matériel tournant. Elle est de préférence réalisée sur le même substrat que les boucles du micro-circuit à bulles.

La boussole comporte avantageusement un disque circulaire en matériau magnétique à haute perméabilité dont une bulle magnétique parcourt la périphérie sous l'action du champ tournant des moyens de lecture, qui est en règle générale créé par des bobines croisées, destiné à amener les bulles des boucles de comptage sous les détecteurs respectifs. La bulle adopte une forme très allongée en raison du disque ci-dessus. Plutôt que de prévoir un seul détecteur permettant de déceler la présence de la bulle sous lui, la boussole comporte avantageusement plusieurs éléments sensibles répartis le long de la périphérie du disque et assemblés dans un montage différentiel. D'autres types de boussole électronique sont utilisables. On peut citer, à titre non limitatif, les capteurs à effet Hall et les capteurs magnéto-résistifs.

Une telle constitution du capteur de position angulaire permet une lecture au vol, car le temps de traitement de l'information fourni par la boussole peut être extrêmement court, étant donné qu'elle se présente comme un signal analogique. Il suffit que les moyens de création du champ électrique tournant de mesure donnent à la vitesse angulaire de ce dernier une valeur très supérieure à la vitesse maximum de rotation du champ tournant de l'aimant. Dans la pratique, le rapport entre les deux vitesses de rotation sera largement supérieur à 100. Cela implique que la propagation des bulles le long des boucles de comptage puisse être réalisée à vitesse élevée : cette condition est remplie si l'on utilise par exemple la technologie de mémoires à bulles de la titulaire de la présente demande, qui permet de faire passer une bulle d'un motif à un autre en dix micro-seconde.

Le nombre maximum de tours que l'on peut compter dans le cas d'une seule boucle de comptage est égal au nombre de motifs dans la boucle. Un tel nombre est généralement très insuffisant. La capacité de comptage peut être augmentée à volonté en utilisant plusieurs boucles parcourues chacune par une bulle ou une séquence de bulles, les boucles ayant des nombres de motifs qui sont premiers entre eux deux à deux. Avec des boucles dont les nombres de motifs sont L1, L2, Ln, on peut alors coder tout nombre entier N compris entre zéro et le produit L1. L2... Ln par application du théorème des restes chinois : la mesure effectuée sur chaque boucle fournit en effet les restes R1,..., Rn de la division euclidienne de N par L1,..., Ln. Des algorithmes simples, tel que celui décrit dans "Chinese Remainder Theorem" par D.E. Knuth, The Art of Computer Programming, vol. 2, p. 270 (1981) permettent de reconstituer N par voie logicielle.

L'invention vise également à réduire le nombre de pas de propagation nécessaires pour obtenir les informations nécessaires à la mesure du nombre de tours. Pour cela, dans un mode avantageux de réalisation, l'invention propose un dispositif dans lequel chaque boucle contient une séquence de bulles constituant un cycle de Bruijn ou une telle séquence tronquée par suppression de zéros se trouvant à la fin. Les cycles de Bruijn sont des séquences cycliques pseudo-aléatoires de $2^m$ bits dont une des propriétés est que toutes les sous-séquences de m bits consécutifs sont différentes.

Par exemple, avec m = 5, un cycle de Bruijn, de longueur $2^5 = 32$, est le suivant :

00000111110111001101011000101001

Un tel cycle peut être tronqué pour le ramener aux longueurs 27 et 29, par exemple de la façon suivante :

00000111110111001101011000101 (longueur 29)
000001111101110011010110001 (longueur 27)

Avec de telles séquences, il suffit de lire 5 bits consécutifs dans chaque boucle pour pouvoir déterminer le nombre de tours, à l'aide d'une table de correspondance stockée dans une mémoire non volatile.

Le caractère homogène et miniaturisable du dispositif suivant l'invention, l'absence de toute consommation en dehors des périodes de génération des bulles et de lecture, la possibilité de lecture au vol étendent encore le champ d'applications potentielles du dispositif. On peut notamment citer, parmi les domaines d'application, les appareils robotiques et de manutention, où un dispositif compteur de tours peut être monté sur l'axe des moteurs pas-à-pas pour fournir leur position exacte, même en cas de panne d'alimentation ; les débit-mètres et les compteurs volumétriques, l'aimant permanent étant constitué par un élément entraîné en rotation par le débit de fluide. Le dispositif peut également constituer un mouchard ou un totalisateur de distance, notamment sur une machine tournante. Suivant l'application envisagée, le lecteur peut être intégré ou non au dispositif.

La boussole miniature constituée par le disque circulaire et son détecteur fournit une information qui non seulement indique l'angle du champ tournant des moyens de mesure, permettant une lecture simple du nombre de tours absolu, mais aussi fournit deux signaux analogiques variant périodiquement sous l'action du champ de l'aimant lors du fonctionnement normal du compteur, en dehors des périodes de lecture, ce qui permet de déterminer la vitesse instantanée de l'organe tournant.

L'invention sera mieux comprise à la lecture de la description qui suit d'un mode particulier de réalisation de l'invention, donné à titre d'exemple non limitatif. La description se réfère aux dessins qui l'accompagnent, dans lesquels :

- la figure 1 est un schéma de principe en perspective montrant une constitution possible de la partie magnétique du dispositif ;
- la figure 2 est un schéma de principe d'une boucle de comptage ;
- la figure 3 est une vue de détail montrant une répartition possible des motifs et des éléments annexes dans une boucle de comptage ;
- les figures 4 et 5 montrent deux dispositions relatives possibles de la puce du dispositif et de l'organe rotatif dont les révolutions sont à compter ;
- la figure 6 montre une disposition relative possible de boucles de comptage et d'une boussole miniature, sur un même substrat ;
- la figure 7 montre une répartition possible de magnéto-résistances de détection dans une boussole miniature ;
- la figure 8 montre un montage possible en double pont des magnéto-résistances de la figure 7 ;
- la figure 9 montre l'allure de la variation des signaux fournis par le montage de la figure 8 ;
- la figure 10 est un synoptique de principe d'un dispositif de mesure complet ;
- les figures 11 et 12 sont des diagrammes montrant la façon dont le champ tournant fourni par l'organe rotatif peut être compensé à l'aide du champ tournant généré uniquement lors des opérations de lecture.

Avant de décrire un dispositif compteur suivant l'invention, on rappellera la constitution d'un microcircuit à bulles magnétiques ; il est réalisable par les technologies de fabrication des puces de mémoire à bulles magnétiques.

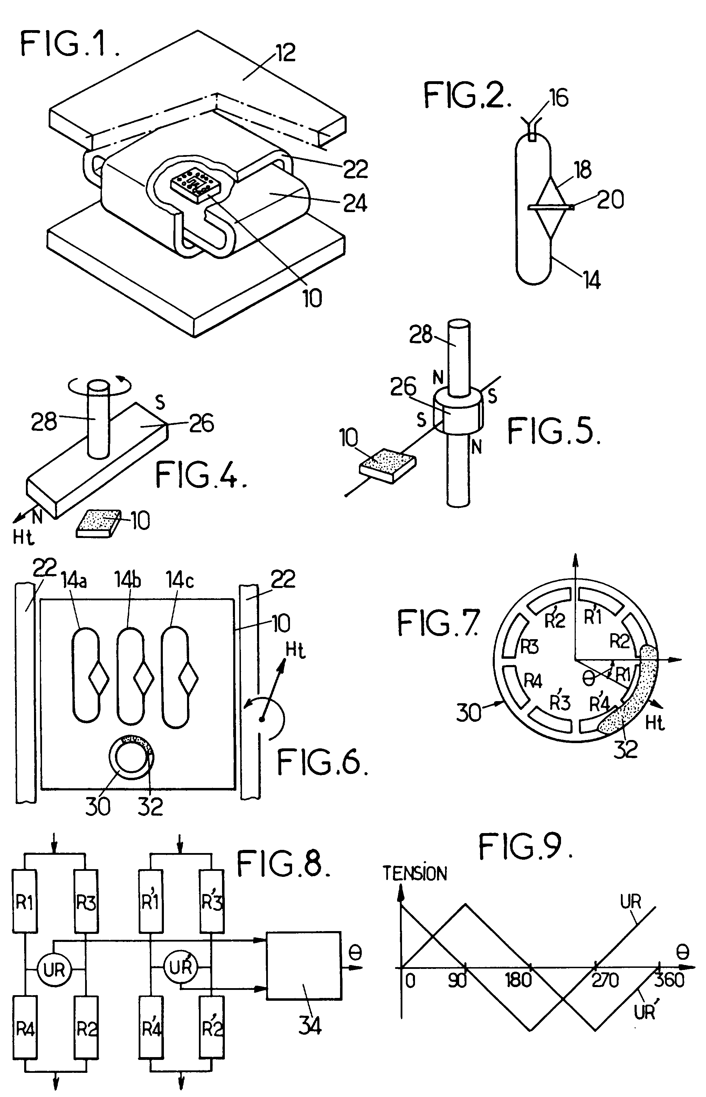

Le micro-circuit à bulles comporte un élément actif constitué par une puce de matériau magnétique dont les dimensions sont généralement inférieures à 2 mm x 2 mm dans le cas de l'invention, alors qu'elles atteignent environ 10 x 10 mm dans le cas d'une mémoire. La puce est encadrée par deux aimants 12, dits aimants de polarisation, destinés à créer un champ magnétique permanent orthogonal au plan de la puce. La puce porte au moins une boucle de comptage 14 (figure 2) constituée de motifs alignés, coopérant avec un générateur de bulles 16 et ayant une zone d'extension de bulles 18 augmentant la sensibilité d'un détecteur 20 de présence de bulles dans la zone située sous lui. Un dispositif suivant l'invention, comme une mémoire, comporte de plus des moyens de création d'un champ tournant permettant de propager les bulles ; ces moyens sont généralement constitués par deux bobines mutuellement orthogonales 22 et 24 alimentables par des courants alternatifs déphasés de 90°.

La boucle ou chaque boucle 14 peut notamment avoir la constitution schématisée en figure 3. Le détecteur 20 est généralement de type magnéto-résistif : dans le cas illustré sur la figure 3, il comprend un détecteur actif 20a et un détecteur passif 20b, constitués l'un et l'autre par une couche magnétique mince dont la résistance varie selon que son aimantation est parallèle ou perpendiculaire au courant détecteur. Le rôle de la zone d'extension est d'allonger la bulle magnétique sur toute la longueur du barreau détecteur de fer-nickel. Le détecteur passif 20b est placé à proximité du détecteur actif 20a mais n'est pas soumis à l'action de la bulle magnétique qui agit sous le détecteur actif, de façon à permettre une mesure différentielle, donc plus sensible.

En général, la mise en oeuvre de l'invention nécessitera que l'on puisse faire circuler les bulles magnétiques le long de la boucle de comptage dans un sens et dans l'autre. Dans ce cas, les motifs seront symétriques et peuvent par exemple avoir la forme classique indiquée en figure 3. Cependant, lorsque l'on ne recherche pas une précision élevée et que l'erreur due à une avancée de quelques motifs le long de la boucle pour la mesure est sans conséquence, on peut admettre d'utiliser des motifs dissymétriques, ne permettant la circulation que dans un seul sens.

Pour la mise en oeuvre de l'invention, chaque puce peut avoir une constitution couramment utilisée pour la fabrication de mémoires à bulles magnétiques : elle est alors constituée par un substrat non magnétique revêtu d'une pellicule épitaxiée de grenat ferri-magnétique, recouverte elle-même d'une couche d'espacement isolante, généralement en silice, d'un espaceur en polyimide sous lequel sont enterrées les pistes de liaison électrique, et enfin les motifs de propagation en fer-nickel épais. Généralement, une couche de passivation recouvre le tout. Les caractéristiques de la pellicule épitaxiée sont avantageusement choisies de façon que le rapport entre l'épaisseur h de la pellicule et la largeur des bandes en champ nul soit compris entre 0,8 et 1,5 et de préférence d'environ 1,1. On augmente ainsi l'excursion admissible du champ de polarisation autour de sa valeur nominale.

Alors que dans une mémoire à bulles magnétiques l'avance des bulles est provoquée uniquement par les moyens de création de champ tournant (bobines 22 et 24 sur la figure 1), un dispositif suivant l'invention comporte un aimant dont la rotation propage les bulles le long de la boucle à la cadence de rotation de l'organe dont les révolutions sont à compter. Dans le cas montré en figure 4, l'aimant 26 est monté en bout d'un arbre 28 dont le nombre de tours est à compter et il est placé au-dessus de la puce magnétique 10. Dans le cas montré en figure 5, l'aimant 26 est quadripolaire et il est monté autour de l'arbre 28 dont la rotation est à mesurer. L'aimant est placé latéralement par rapport à la puce 10 et provoquera, à chaque tour de l'arbre, une avancée des bulles de deux motifs. Dans tous les cas, le champ Ht créé par l'aimant 26 doit tourner dans le plan des boucles de la puce 10. Les dispositions des figures 4 et 5 permettront d'atteindre ce résultat, mais elles ne sont nullement exclusives.

Pour permettre la mesure d'un nombre de tours notable, le dispositif utilise généralement non pas une seule boucle de comptage 14 mais plusieurs. Dans le cas représenté sur la figure 6, la puce 10 porte trois boucles ayant des nombres de motifs différents et premiers entre eux. On s'attachera notamment par la suite au cas de boucles ayant respectivement L1 = 27, L2 = 29 et L3 = 32 motifs, ce qui permet de mesurer un nombre maximum de tours égal à L1.L2.L3 = 25 056. Ce nombre n'est pas limitatif. On pourrait par exemple utiliser des longueurs de 46, 47 et 49 ou encore 77, 78 et 79. Dans ce dernier cas, le produit L1.L2.L3 est égal à 474 474.

Conformément à un aspect de l'invention, la puce 10 comporte également une boussole électronique miniature 30 permettant de mesurer ou au moins de détecter l'orientation du champ tournant créé par les bobines 22 et 24 et en conséquence celui créé par le champ tournant Ht.

Dans un mode avantageux de réalisation, cette boussole 30 est constituée par un disque circulaire en matériau magnétique à perméabilité élevée (fer-nickel par exemple). Ce disque est muni d'un générateur d'une bulle magnétique (non représenté). Le champ de fuite maintient la bulle à la périphérie du disque. Pour permettre de connaître à tout instant la position de la bulle magnétique unique 32 qui la parcourt, le disque circulaire est équipé de plusieurs détecteurs magnéto-résistifs régulièrement répartis le long de sa circonférence. Dans le cas illustré sur la figure 7, le disque comporte huit magnéto-résistances, désignées successivement par les références R1, R2, R'1, R'2,..., R'4 dont la position est bien déterminée par rapport à deux axes de référence orthogonaux $\underline{x}$ et $\underline{y}$ et par rapport à la disposition du détecteur 20 de la boucle de comptage 14 ou de chaque boucle. Huit capteurs sont suffisants pour fournir l'orientation θ du champ Ht avec la précision nécessaire. Il est avantageux que la bulle magnétique, créée à l'aide d'un générateur non représenté, ait une longueur importante, débordant sur plusieurs capteurs magnéto-résistifs.

Dans le cas où on utilise huit magnéto-résistances, ces dernières sont avantageusement montées en double pont comme l'indique la figure 8. On alimente chaque pont sous un même courant déterminé. Etant donné que la résistance des magnéto-résistances diminue en présence de la bulle magnétique, les tensions UR et UR' dans les diagonales varient en fonction de l'angle θ suivant le diagramme de la figure 9. Chaque tension est triangulaire et les tensions sont en quadrature de phase. A partir de ces tensions, un circuit analogique simple 34 permet de déterminer l'angle θ fait par la bulle avec l'axe de référence x et, en conséquence, l'angle du champ tournant Ht.

A condition que le dispositif comporte des moyens de mesure de la position de la bulle, le circuit 34 peut fournir en permance l'angle θ fait par l'arbre 28 avec l'axe de référence x.

Comme on l'a indiqué plus haut, le dispositif est avantageusement initialisé en chargeant, dans les boucles 14 et à l'aide du générateur 16, des séquences binaires constituant des cycles de Bruijn tels que ceux mentionnés plus haut. Dans le cas de boucles de comptage ayant des longueurs égales à 27, 29 et 32, il suffit d'une séquence dont l'emplacement dans la boucle peut être reconnu par lecture de m = 5 bits successifs.

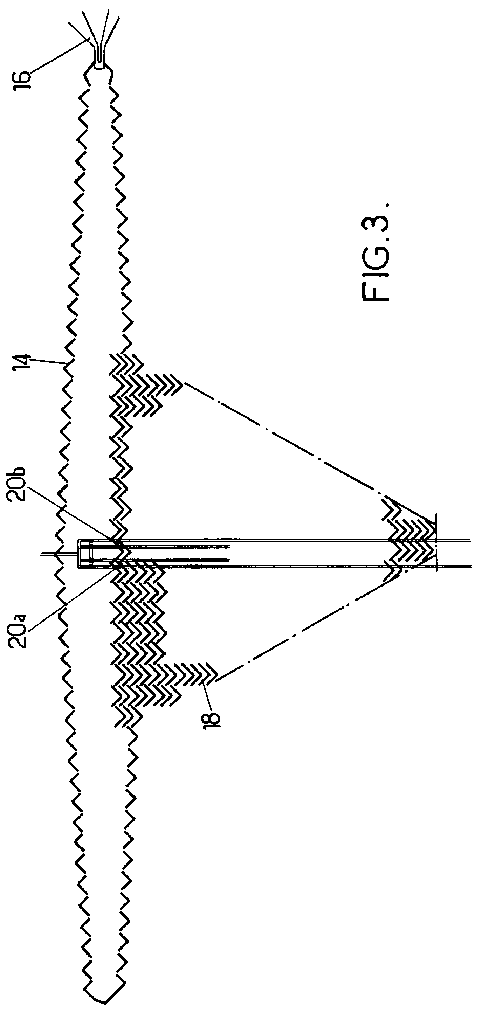

La constitution globale du dispositif peut être celle schématisée en figure 10. L'angle θ est fourni sous forme analogique à un convertisseur analogique-numérique 36 fournissant un signal représentatif de l'angle θ sous forme numérique à un microprocesseur 38. A ce microprocesseur est reliée une mémoire non volatile 40, par exemple de type électriquement programmable ou EPROM, qui stocke la table de correspondance entre chaque mot de 5 bits lu et la position dans la boucle, codable sur 5 bits dans le cas où les boucles de comptage ont des longueurs égales à 27, 29 et 32.

Les signaux de sortie fournis par les capteurs 20 attaquent le microprocesseur par l'intermédiaire de circuits à seuil 42 destinés à écarter les parasites. L'algorithme de restitution du nombre de tours en fonction de la position relative des séquences dans les différentes boucles est mémorisé dans le calculateur ou dans une mémoire annexe. Le microprocesseur 38 fournit ainsi un signal numérique représentatif du nombre de tours sur une sortie 42. Il permet également de fournir à un circuit complémentaire de calcul 44 les informations nécessaires au calcul de la phase de démarrage du champ tournant à créer par les bobines 22 et 24. Les courants alternatifs de création du champ tournant sont alors générés par des circuits fournissant des créneaux de tension associés à des amplificateurs de puissance de sortie 46 et 48.

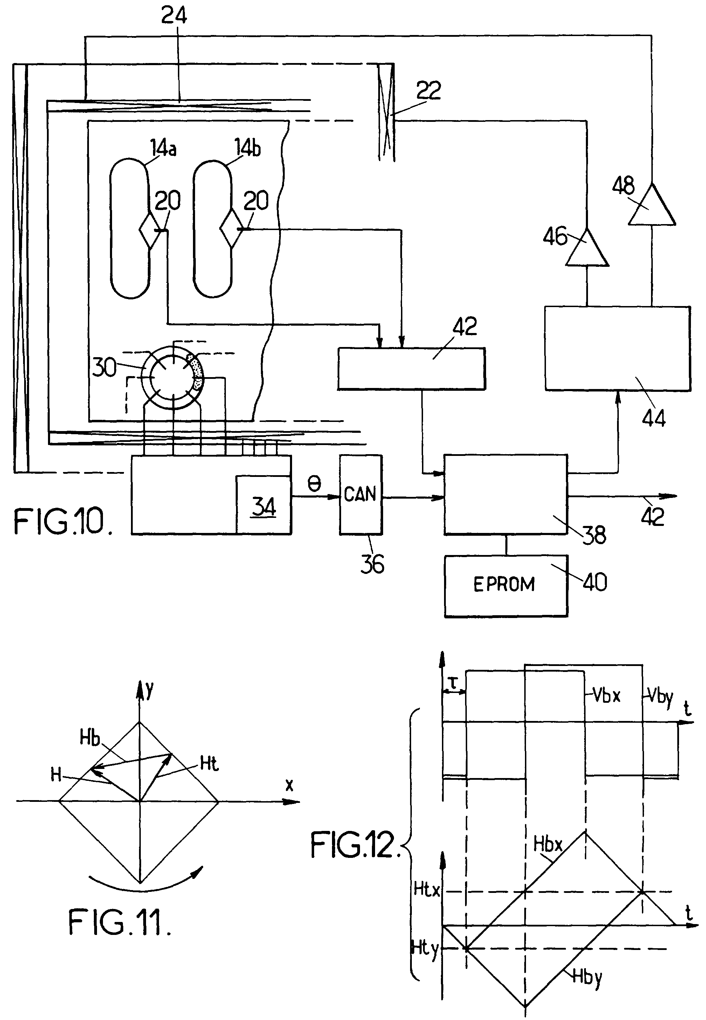

Le champ tournant créé par les bobines de lecture 22 et 24 est avantageusement à enveloppe carrée, comme indiqué sur la figure 11, plutôt que d'amplitude constante. Le champ tournant effectivement appliqué pendant la mesure est constitué par la résultante du champ Ht fourni par l'aimant 26 (qui peut être un champ tournant Ht lorsque la lecture s'effectue "au vol") et du champ Hb fourni par les bobines. Les bulles circulent alors dans les boucles de mesure et autour du disque circulaire de la boussole à la vitesse du champ résultant H. Il est nécessaire que la vitesse de rotation du champ résultant H soit très supérieure à celle de Ht lorsqu'on veut effectuer une mesure au vol, afin que Ht ne change pas sensiblement d'orientation pendant la mesure. A titre d'exemple, lorsque la vitesse maximale de rotation des champs Ht est de 20 000 t/mn, on peut adopter une fréquence de propagation des bulles magnétiques de 100 KHz lors de la lecture, c'est-à-dire une valeur trois cents fois supérieure à la fréquence qui correspond à la vitesse maximale de comptage.

L'orientation de Ht étant connue par l'indication fournie par la boussole, l'obtention d'un champ résultant H à enveloppe rectangulaire peut être obtenue en appliquant aux deux bobines 22 et 24, deux tensions carrées Vbx et Vby en quadrature de phase avec une phase initiale τ convenable, déterminée par le circuit 44. La phase τ (figure 12) est destinée à compenser le champ Ht pendant la lecture : comme le montre la seconde ligne de la figure 12, les composantes triangulaires Hbx et Hby dues aux bobines sont respectivement centrées autour d'une valeur positive - Htx et négative - Hty qui sont les composantes de Ht suivant les deux axes x et y.

Lorsque l'on souhaite que la lecture ne perturbe pas l'information mémorisée, il faut ramener le compteur à sa position originale en effectuant m = 5 tours en sens inverse après chaque opération de lecture.

L'algorithme de calcul du nombre de tours N peut notamment être le suivant, lorsque le dispositif comporte trois boucles et que les nombres de rotations détectés pour les trois boucles sont N1, N2 et N3 :

$$E1 = N1 \ [27]$$

$$E2 = 406 \ E1 + 378 \ N2 \ [783]$$

$$N = E2 + 11745 \ (N3\text{-}E2) \ [25056]$$

Dans ces formules, E1 et E2 désignent les résultats de calculs intermédiaires et l'indication [ ] signifie modulo le chiffre qui est à l'intérieur. L'algorithme étant très simple, il peut être exécuté en quelques millisecondes.

L'invention est susceptible de nombreuses variantes de réalisation. En particulier la boussole électronique miniature peut utiliser des capteurs de champ statiques de divers types connus. Une solution intéressante utilise deux capteurs à effet Hall placés à 90° l'un de l'autre à proximité du micro-circuit, ou davantage.

## Revendications

1. Dispositif de comptage du nombre de tours d'un organe rotatif, comprenant un aimant (26), constituant l'organe rotatif (28) ou porté par lui, et un micro-circuit ayant un substrat portant des boucles de comptage (14a,14b,14c) à circulation de bulles magnétiques, placées par rapport à l'aimant de façon que le champ tournant (Ht) de l'aimant fasse passer les bulles d'un motif des boucles au motif suivant à chaque tour du champ,

caractérisé en ce qu'il comprend de plus une boussole électronique sensible au champ magnétique tournant des moyens de lecture équipant la mémoire.

2. Dispositif selon la revendication 1, caractérisé en ce que la boussole miniature est réalisée sur le même substrat que les boucles de la mémoire à bulles.

3. Dispositif selon la revendication 1 ou 2, caractérisé en ce que ladite boussole comporte un disque circulaire (30) constitué en matériau magnétique à haute perméabilité, dont une bulle magnétique parcourt la périphérie sous l'action du champ tournant des moyens de lecture et au moins un détecteur de position de ladite bulle magnétique.

4. Dispositif selon la revendication 3, caractérisé en ce que ladite boussole comprend plusieurs magnéto-résistances de détection régulièrement réparties autour du disque et assemblées électriquement dans un montage différentiel.

5. Dispositif selon la revendication 4, caractérisé en ce que le disque circulaire contient une bulle magnétique (32) allongée dans le sens circonférentiel suffisamment pour déborder sur plusieurs magnéto-résistances.

6. Dispositif selon la revendication 3, caractérisé en ce que ladite boussole comporte au moins deux capteurs à effet Hall orientés à 90° l'un de l'autre et placés à proximité du micro-circuit.

7. Dispositif selon l'une quelconque des revendications 1 à 6, caractérisé en ce que les moyens de lecture comprennent des moyens de création d'un champ électrique tournant de mesure à une vitesse angulaire ayant une valeur très supérieure à la vitesse maximum de rotation du champ tournant (Ht) de l'aimant (26).

8. Dispositif selon l'une quelconque des revendications précédentes, caractérisé en ce qu'il comporte plusieurs boucles de comptage ayant des nombres de motifs qui sont premiers entre eux.

9. Dispositif selon l'une quelconque des revendications précédentes, caractérisé en ce que chaque boucle de comptage contient, lors du fonctionnement, une séquence de bulles constituant un cycle de Bruijn constituant une séquence pseudo-aléatoire de $2^m$ bits ou résultant d'une troncature d'une telle séquence par suppression de zéros à la fin et en ce que le dispositif comprend des moyens de traitement de signal permettant d'identifier la position de la séquence par lecture de $\underline{m}$ bits successifs.

10. Dispositif suivant l'une quelconque des revendications précédentes, caractérisé en ce que lesdites boucles de comptage sont constituées sur une pellicule épitaxiée de caractéristiques telles que le rapport entre l'épaisseur h de la pellicule et la largeur des bandes en champ nul soit compris entre 0,8 et 1,5 et de préférence d'environ 1,1.

**Patentansprüche**

1. Vorrichtung zur Messung der Umdrehungen eines rotierenden Organes, mit einem Magneten (26), der das rotierende Organ bildet oder von diesem getragen wird, und einem Mikro-Schaltkreis, der ein Substrat aufweist, welches Zählschleifen (14a, 14b, 14c) zur Zirkulation magnetischer Blasen trägt, die bezüglich des Magneten derart angeordnet sind, daß das drehende Feld (Ht) des Magneten die magnetischen Blasen bei jeder Umdrehung des Feldes von einem Schleifenmuster zu einem folgenden Muster passieren läßt, dadurch gekennzeichnet, daß sie zusätzlich einen elektronischen Kompaß umfaßt, der empfindlich gegenüber dem drehenden Magnetfeld der Leseeinrichtungen ist, welcher den Speicher lädt.

2. Vorrichtung nach Anspruch 1, dadurch gekennzeichnet, daß der Miniaturkompaß auf dem selben Substrat ausgebildet ist, wie die Schleifen des Blasenspeichers.

3. Vorrichtung nach Anspruch 1 oder 2, dadurch gekennzeichnet, daß der Kompaß eine runde Scheibe (30) umfaßt, die aus einem magnetischen Material mit hoher Permeabilität besteht, wobei eine magnetische Blase deren Peripherie unter der Wirkung des drehenden Feldes der Leseeinrichtungen umläuft, sowie zumindest eine Erfassung der Position der magnetischen Blase.

4. Vorrichtung nach Anspruch 3, dadurch gekennzeichnet, daß der Kompaß mehrere magnetische Widerstände zur Erfassung aufweist, die regelmäßig um die Scheibe verteilt sind und elektrisch in einer Differentialschaltung zusammengefaßt sind.

5. Vorrichtung nach Anspruch 4, dadurch gekennzeichnet, daß die runde Scheibe eine im Umfangssinne ausreichend verlängerte magnetische Blase (32) enthält, um sich über mehrere magnetische Widerstände zu erstrecken.

6. Vorrichtung nach Anspruch 3, dadurch gekennzeichnet, daß der Kompaß zumindest zwei Hall-Effekt-Sonden aufweist, die um 90° zueinander und in der Nähe des Mikro-Schaltkreises angeordnet sind.

7. Vorrichtung nach einem der Ansprüche 1 bis 6, dadurch gekennzeichnet, daß die Leseeinrichtungen Einrichtungen umfassen, um ein drehendes elektrische Feld zur Messung zu schaffen, mit einer Winkelgeschwindigkeit, die einen sehr viel höheren Wert als die maximale Rotationsgeschwindigkeit des drehenden Feldes (Ht) des Magneten (26) hat.

8. Vorrichtung nach einem der vorhergehenden Ansprüche, dadurch gekennzeichnet, daß sie mehrere Zählschleifen umfaßt, die mehrere Motive haben, welche einzig unter ihnen sind.

9. Vorrichtung nach einem der vorhergehenden Ansprüche, dadurch gekennzeichnet, daß jede Zählschleife während des Betriebes eine Sequenz von Blasen hat, die einen Bruijn-Zyklus bilden, der eine Pseudo-Zufallssequenz mit $2^m$ Bits bildet oder zu einer Verkürzung einer derartigen Sequenz durch Unterdrückung der Nullen am Ende führt, und dadurch, daß die Einrichtung zur Sinalbearbeitung umfaßt, die es ermöglichen, die Position der Sequenz durch Lesen der aufeinanderfolgenden m Bits zu identifizieren.

10. Vorrichtung nach einem der vorhergehenden Ansprüche, dadurch gekennzeichnet, daß die Zählschleifen auf einem epitaxierten Film ausgebildet sind, mit einer derartigen Charakteristik, daß das Verhältnis zwischen der Dicke h des Filmes und der Breite der Bänder ohne Feld zwischen 0,8 und 1,5 liegt und vorzugsweise um 1,1.

## Claims

1. A device for counting the number of revolutions of a rotating component, comprising a magnet (26) which either constitutes or is carried by the rotating component (28), and a microcircuit having a substrate carrying magnetic bubble type counting loops (14a, 14b, 14c) so disposed relatively to the magnet that the rotating field (Ht) of the magnet causes the bubbles to pass from one pattern of the loops to the next pattern on each revolution of the field,
   characterised in that it also comprises an electronic compass sensitive to the rotating magnetic field of the reading means with which the memory is equipped.

2. A device according to claim 1, characterised in that the miniature compass is formed on the same substrate as the bubble memory loops.

3. A device according to claim 1 or 2, characterised in that the said compass comprises a circular disc (30) made of a high-permeability magnetic material, one magnetic bubble of which traverses the periphery under the action of the rotating field of the reading means and at least one detector for the position of the said magnetic bubble.

4. A device according to claim 3, characterised in that the said compass comprises a plurality of detection magnetoresistances uniformly distributed around the disc and connected electrically in a differential circuit.

5. A device according to claim 4, characterised in that the circular disc contains a magnetic bubble (32) which is elongated in the circumferential direction sufficiently to extend over a plurality of magnetoresistances.

6. A device according to claim 3, characterised in that the said compass comprises at least two Hall effect sensors oriented at 90° to one another and disposed near the microcircuit.

7. A device according to any one of claims 1 to 6, characterised in that the reading means comprise means for creating a rotating measuring electric field at an angular velocity very much greater than the maximum velocity of rotation of the rotating field (Ht) of the magnet (26).

8. A device according to any one of the preceding claims, characterised in that it comprises a plurality of counting loops having numbers of patterns which are prime numbers in relation to one another.

9. A device according to any one of the preceding claims, characterised in that each counting loop contains, on operation, a bubble sequence constituting a Bruijn cycle constituting a pseudo-random sequence of $2^m$ bits or resulting from a truncation of such a sequence by suppression of zeros at the end and in that the device comprises signal processing means allowing identification of the position of the sequence by reading m successive bits.

10. A device according to any one of the preceding claims, characterised in that the said counting loops are formed on an epitaxial film having characteristics such that the ratio between the thickness h of the film and the width of the zero field bands is between 0.8 and 1.5 and preferably approximately 1.1.

FIG.1.

FIG.2.

FIG.4.

FIG.5.

FIG.6.

FIG.7.

FIG.8.

FIG.9.

FIG.3.

EP 0 554 184 B1

FIG.10.

FIG.11.

FIG.12.